# EUROPÄISCHE PATENTSCHRIFT

(11) **EP 0 518 325 B1**
(45) Veröffentlichungstag und Bekanntmachung des Hinweises auf die Patenterteilung: **24.05.1995**
(21) Anmeldenummer: 92109840.6
(22) Anmeldetag: 11.06.1992
(51) Int. Cl.: H01L 21/20, H01L 21/205

(54) **Epitaxierte Halbleiterscheiben mit sauerstoffarmer Zone einstellbarer Ausdehnung und Verfahren zu ihrer Herstellung**
Epitaxial semiconductor chip with low oxygen zone of adjustable thickness and process of making same
Pastille semi-conductrice épitaxiée avec zone pourvue en oxygène d'épaisseur réglable et son procédé de fabrication

(30) Priorität: 13.06.1991 DE 4119531
(43) Veröffentlichungstag der Anmeldung: 16.12.1992
(73) Patentinhaber: Wacker-Siltronic Gesellschaft für Halbleitermaterialien mbH, D-84489 Burghausen (DE)
(72) Erfinder: Schauer, Reinhard, W-8229 Laufen (DE)
(74) Vertreter: Rimböck, Karl-Heinz, Dr.

(56) Entgegenhaltungen:
- EP-A- 0 265 988
- EP-A- 0 438 959
- EXTENDED ABSTRACTS ,FALL MEETING, SEATTLE, WASHINGTON,OKT.14-19,1990 90/2(1990) PRINCETON, NEW JERSEY US Seiten 576 - 577 J. MUROTA ET AL 'LOW-TEMPERATURE SILICON EPITAXY WITH HIGH THROUGHPUT USING ULTRACLEAN LOW-PRESSURE CVD PROCESSING'
- TEMPERATURE SILICON EPITAXY WITH HIGH THROUGHPUT USING ULTRACLEAN LOW-PRESSURECVD PROCESSING' DIE GANZE DOKUMENT
- JOURNAL OF THE ELECTROCHEMICAL SOCIETY Bd. 122, Nr. 11, November 1975,MANCHESTER, NEW HAMPSHIRE US Seiten 1523 - 1531 T.ISHII ET AL. 'SILICONEPITAXIAL WAFER WITH ABRUPT INTERFACE BY TWO-STEP EPITAXIAL GROWTH TECHNIQUE'
- S.M.Sze: "SEMICONDUCTOR DEVICES, Physics and Technology", John Wiley & Sons, Kapitel 8, Seiten 318-324
- SOLID STATE TECHNOLOGY, Vol.11(6), 1988, Seiten 24-26 (Japanische Ausgabe)

## Beschreibung

Die Erfindung betrifft ein Verfahren zur Herstellung von epitaxierten Halbleiterscheiben mit sauerstoffarmer Zone, gebildet durch Epitaxie einkristalliner Substratscheiben im Einzelscheibenreaktor. Die Erfindung betrifft ferner nach diesem Verfahren hergestellte Halbleiterscheiben.

In Halbleiterscheiben, insbesondere aus Silicium, die zur Herstellung elektronischer Bauelemente verwendet werden und durch Zersägen stab- oder blockförmiger Werkstücke hergestellt werden, finden sich in der Regel Sauerstoffkonzentrationen bis zu 9 x 10¹⁷ Atome/cm³. Dieser Sauerstoffgehalt, der verfahrensbedingt durch die Verwendung von Werkstücken aus Quarz, beispielsweise den Tiegeln zum Kristallziehen nach Czochralski, in das Halbleitermaterial eingetragen wird, ist durchaus erwünscht, weil er im Kristallgitter als Gitterstörung Keimzentren für weitere Verunreinigungen darstellt. Dieser als "internal gettering" bekannte Reinigungseffekt durch Konzentrierung der Restfremdstoffe ist aber nur im Inneren der Halbleiterscheibe nützlich. Im Oberflächenbereich der Siliciumscheiben, in dem die elektronischen Bauelemente integriert werden, stören diese Sauerstoffzentren erheblich. Infolge der bei der Bauelementherstellung anfallenden Verfahrensschritte, wie beispielsweise Epitaxie, Dotierstoffbehandlung, Oxidation und den damit verbundenen Temperschritten neigen die Sauerstoffzentren zur Präzipitatbildung und verursachen dadurch Spannungen im Kristallgitter, die ihrerseits den Ausfall ganzer Bauelementgruppen zur Folge haben.
Es ist daher erwünscht, Scheiben zu verwenden, die eine mehrere »m dicke, an Sauerstoff verarmte Oberflächenzone enthalten (sogenannte denuded zone). Verfahren zur Herstellung einer denuded zone sind seit langem bekannt. So kann durch Tempern von Siliciumscheiben in einem Ofen (bei Temperaturen von beispielsweise 1000°C - 1200°C) unter Inertgasatmosphäre der Sauerstoff an der Oberfläche zum Ausdiffundieren gebracht werden. Nach einer Zeit von 5 Stunden bei einer Temperatur von 1000°C beträgt die allein durch ausdiffundierenden Sauerstoff erreichbare Schichtdicke der denuded zone mehr als 10 »m (Huber, D.; Reffle, J.; Solid State Techn. 26(8) 1983, Seite 138).
Die Erzeugung einer denuded zone wird vorteilhaft vor, während oder nach der im Rahmen der Bauelementherstellung notwendigen Abscheidung einer dotierten epitaktischen Schicht durchgeführt, weil beide Vorgänge ähnliche Prozeßtemperaturen erfordern und sich nicht gegenseitig behindern. Die Stärke der entstehenden denuded zone richtet sich im wesentlichen nach den gewährten Diffusionszeiten.

Das Aufbringen einer Epitaxieschicht dient in der Regel der Erzeugung eines scharfen Übergangs in den elektrischen Eigenschaften im Halbleitermaterial. Normalerweise ist ein steiler Anstieg im Widerstandsprofil beim Übergang vom Substrat zur oberflächennahen Epitaxieschicht erwünscht. Substrat und Epitaxieschicht sind deshalb üblicherweise unterschiedlich dotiert.

Entsprechend dieses Standes der Technik wurde der denuding Schritt bisher in einem Batch-Epitaxiereaktor ausgeführt. Das sind Reaktoren mit einer Aufnahmekapazität von mehr als einer, in der Regel 4-50 Scheiben. Diese Reaktoren haben, bedingt durch den Zeitbedarf zum Abscheiden der Epitaxieschicht (Aufwachsraten bei diesem Reaktortyp: 1 »m bis 2 »m pro Minute) ausreichend lange Zykluszeiten, um auch die Ausbildung einer die bisher geforderten Spezifikationen - die Stärke der einzuhaltenden sauerstoffarmen oberflächennahen Schicht soll mindestens 5 »m betragen - erfüllenden denuded zone zu erlauben. Allerdings sind die von den Bauelementherstellern gestellten Erwartungen an die Qualität und Ausdehnung der denuded zone gestiegen. Um den Anforderungen zu genügen, müssen wachsende Verweilzeiten der Scheiben im Batchreaktor in Kauf genommen werden, wodurch das Verfahren zunehmend unwirtschaftlich wird.

Batchreaktoren besitzen außerdem einige Nachteile, die dazu geführt haben, daß mittlerweile für Epitaxieprozesse sogenannte Einzelscheibenreaktoren bevorzugt verwendet werden. Als Folge der langen Bearbeitungszeit der Scheiben im Batchreaktor diffundieren Dotierstoffe aus dem Substrat und werden teilweise in die aufwachsende Epitaxieschicht eingebaut. Dabei wird das angestrebte steile Widerstandsprofil beim Übergang vom Substratmaterial zur Epitaxieschicht in nicht zu tragender Weise abgeschwächt (Autodopingeffekt). Ähnliche Schwierigkeiten treten dadurch auf, daß im Laufe einer Folge von Bearbeitungsschritten gezielt eingetragene Dotierungsstoffe aus dem relativ großen Volumen derartiger Reaktoren kaum vollständig entfernt werden können und später unerwünscht in die Epitaxieschicht aufgenommen werden (Memoryeffekt). Die in zunehmendem Maße zu verarbeitenden großen Scheiben mit Durchmessern von 150 mm bis 200 mm und darüber verschärfen diese Problematik und machen die Verwendung herkömmlicher Batchreaktoren zusätzlich immer unattraktiver.

Einzelscheibenreaktoren besitzen höhere Aufwachsraten (5 »m/min und höher) und ermöglichen damit die Epitaxie auch großer Scheiben in kürzeren Zeiträumen, wobei die geschilderten, bei der Verwendung von Batchreaktoren auftretenden Probleme ohne Bedeutung sind.
Nachteilig bei der Benutzung von Einzelscheibenreaktoren ist jedoch, daß die Verweilzeit der Scheibe im Reaktor nicht ausreicht, um die geforderte Ausdehnung der denuded zone ausschließlich durch Tempern zu erzielen. Man kann die Ausdehnung der denuded zone zwar durch zusätzliches Tempern auf ein ausreichendes Maß steigern, dadurch wird jedoch insbesondere bei hohem Substratsauerstoffgehalt die Wirtschaftlichkeit des Verfahrens stark herabgesetzt. Der Einsatz von sauerstoffarmen Substratscheiben ist jedoch ausgeschlossen, weil das eingangs beschriebene internal gettering bei derartigem Material nur unzureichend zum Tragen kommt.

Die Aufgabe der Erfindung war es daher, ein Verfahren anzugeben, das es ermöglicht, epitaxierte Scheiben mit einer denuded zone einstellbarer Ausdehnung in einem Einzelscheibenreaktor wirtschaftlich herzustellen. Ferner sollten nach diesem Verfahren hergestellte Scheiben beim Übergang von der denuded zone zur oberflächennahen Epitaxieschicht ein steiles Widerstandsprofil aufweisen.

Gelöst wird die Aufgabe durch ein Verfahren zur Herstellung von epitaxierten Halbleiterscheiben mit sauerstoffarmer Zone, gemäß des kennzeichnenden Teils des Anspruchs 1 in der Version A für die benannten Vertragsstaaten DE, FR, GB bzw. in der Version B für die benannten Vertragsstaaten BE, IT, NL.

Die nach dem erfindungsgemäßen Verfahren verwendeten Einzelscheibenreaktoren sind dem Fachmann bekannt und beispielsweise in Solid State Technology, 11(6) 1988, Seiten 24-26 (Japanische Ausgabe) beschrieben. Sie zeichnen sich dadurch aus, daß jeweils nur eine Scheibe pro Arbeitsgang bearbeitet wird. In einer Prozeßkammer, die im Vergleich mit den bei Batchreaktoren verwendeten relativ klein sein kann, beispielsweise mit einem Volumen von vier Litern, wird eine Scheibe, die auf einer Substrathalterung lagert, durch Heizlampen oder über eine Widerstandsheizung beheizt. Beim Durchströmen von Prozeßgas scheidet sich eine Epitaxieschicht auf der Substratscheibe ab.

Diese Art von Reaktoren ist besonders für die Bearbeitung von Scheiben großer Durchmesser von 150 mm bis 200 mm und darüber geeignet, aber auch kleinere Scheiben mit Durchmessern zwischen 75 mm und 150 mm lassen sich darin epitaxieren.
Die erzielbaren Aufwachsraten von 5 »m/min und mehr sind so hoch, daß eine wirtschaftliche Erzeugung von größeren Schichtdicken - je nach Scheibendurchmesser - bis zu 100 »m ermöglicht wird.

Als Substrat dienen bevorzugt einkristalline Scheiben aus Silicium, die abhängig vom geforderten Widerstand Dotierstoffe wie beispielsweise Bor, Antimon, Phosphor oder Arsen enthalten können. Die Kristallorientierung ist nicht eingeschränkt, insbesondere werden jedoch 250 »m bis 1000 »m dicke Scheiben mit einer 1-0-0 und 1-1-1 Orientierung verwendet.

Erfindungsgemäß entsteht die sauerstoffarme Zone auf dem Substrat nicht in erster Linie durch die Ausdiffusion von Sauerstoff aus dem Substrat, sondern vorallem durch die Abscheidung einer ersten sauerstofffreien Epitaxieschicht auf dem Substrat. Die Scheibendicke erhöht sich durch die Abscheidung der ersten Epitaxieschicht je nach Prozeßbedingungen um 1 »m bis 20 »m, bevorzugt jedoch um 5 »m bis 10 »m. Die Ausdehnung der entstehenden denuded zone entspricht der Summe der Ausdehnung von erster Epitaxieschicht und des durch Ausdiffusion von Sauerstoff während der Epitaxie entstandenen sauerstoffarmen Substratbereiches. Sie ist mithin in weiten Grenzen durch die Wahl der Schichtdicke der ersten Epitaxieschicht variierbar. Die Dotierung der ersten Epitaxieschicht wird vorteilhafterweise derartig gewählt, daß Substrat und Epitaxieschicht denselben oder einen in engen Toleranzen von 5 % bis 20 %, vorzugsweise von 5 % bis 10 % ähnlichen spezifischen Widerstand besitzen. Der spezifische Widerstand des Substrates hat in der Regel einen Wert von 0.005 Ohm cm bis 100 Ohm cm, insbesondere von 0.005 Ohm cm bis 0.05 Ohm cm. Die Erfindung erlaubt aber grundsätzlich auch die Abscheidung einer ersten Epitaxieschicht mit einem vom Substrat verschiedenen spezifischen Widerstand.

Vor dem Aufbringen einer Epitaxieschicht erfolgt zweckmäßigerweise eine Vorreinigung von Reaktorkammer und Substratoberfläche. Bevorzugt besteht diese Vorreinigung in einer Spülung des Reaktionsraumes mit Inertgas, beispielsweise mit Stickstoff und in einer Oberflächenbehandlung der Scheiben mit Ätzgas, beispielsweise mit Chlorwasserstoff, gefolgt von einer neuerlichen Spülung mit Inertgas. Einer derartigen Vorreinigung kann aber auch der unbeladene Reaktor alleine unterzogen werden, insbesondere wenn die Reinigungsbedingungen der Halbleiterscheibe schaden könnten.

Die in der Siliciumepitaxie eingesetzten Prozeßgase sind wohl bekannt. Als Spülgase finden bevorzugt Stickstoff, Argon oder Wasserstoff Verwendung. Als Trägergas für die Silicium abscheidenden Gase, wie beispielsweise Tetrachlorsilan, Trichlorsilan, Dichlorsilan oder Silan dient vorzugsweise Wasserstoff. Die Dotierstoffe werden in Form ihrer gasförmigen Verbindungen, etwa Diboran, Phosphin oder Arsin mit Wasserstoff zu Dotiergas gemischt. Chlorwasserstoff ist ein bevorzugtes Ätz- und Reinigungsgas.

Die Abscheidung von Silicium erfolgt vorteilhaft bei einer Temperatur von 900°C - 1250°C, insbesondere von 1100°C - 1200°C. Während des Ätzvorganges werden vorzugsweise Temperaturen von 900°C - 1300°C, insbesondere 1200°C eingestellt. Die Epitaxie wird normalerweise unter Atmosphärendruck durchgeführt, jedoch ist in besonderen Prozeßvarianten auch eine Abscheidung bei Unterdruck bis 13.3 hPa (10 Torr) möglich. Es hat sich als günstig erwiesen, währenddessen die Scheibenhalterung mit einer Rotationsgeschwindigkeit von 1 U/min - 50 U/min, insbesondere mit 25 U/min rotieren zu lassen.

Nach dem erfindungsgemäßen Abscheiden einer ersten Epitaxieschicht mit gleichem oder ähnlichem spezifischen Widerstand unter Ausbildung einer diese Schicht und einen oberflächennahen Teil des Substrates umfassenden denuded zone folgt in der Regel das Aufwachsen einer zweiten Epitaxieschicht. Diese zweite Schicht besitzt normalerweise einen höheren spezifischen Widerstand als ihn Substrat und erste epitaktisch abgeschiedene Schicht aufweisen.

Die Abscheideraten bei der Epitaxie betragen üblicherweise 2 »m/min bis 6 »m/min, bevorzugt 5 »m/min. Der Durchsatz siliciumhaltiger Prozeßgase durch den Reaktor, beispielsweise an Trichlorsilan beträgt zwischen 1 g/min und 50 g/min, insbesondere 20 g/min. Spülgas, beispielsweise Stickstoff oder Wasserstoff, wird in der Regel mit 1 Standardliter pro Minute (SLM) bis 200 SLM durch den Reaktor geleitet, typisch sind Durchflußraten von 20 SLM bis 80 SLM.

Die Durchflußraten von Ätzgas, beispielsweise Chlorwasserstoff haben Werte zwischen 1 SLM und 20 SLM, bevorzugt 20 SLM.
Der im Dotiergas enthaltene Anteil an Dotierstoff, beispielsweise Diboran beträgt 10 ppm bis 10000 ppm, typischerweise 1000 ppm. Der Durchsatz an Dotiergas wird der angestrebten Dotierstoffkonzentration in der Epitaxieschicht angepaßt. Er liegt für die erste abgeschiedene Schicht im Bereich von 1 SLM bis 4 SLM, bevorzugt bei 2 SLM und für die zweite Schicht von 1 Standardkubikzentimeter pro Minute (SCCM) bis 200 SCCM, bevorzugt bei 100 SCCM.

Das erfindungsgemäße Verfahren wird zur Herstellung von epitaxierten Halbleiterscheiben, insbesondere solchen aus Silicium, mit einer denuded zone einstellbarer Ausdehnung verwendet. Als besonders günstig hat sich das Verfahren bei der Herstellung von Scheiben mit einem großen Durchmesser, etwa von mindestens 150 mm erwiesen. Vorteilhaft wird es bei Scheiben mit Kristallorientierungen von 1-0-0 oder 1-1-1 eingesetzt. Die bevorzugt verwendeten Scheibendicken betragen 725 »m. Der spezifische Widerstand des eingesetzten Substrates beträgt 0,005 Ohm cm bis 100 Ohm cm, insbesondere 0,005 Ohm cm bis 0,05 Ohm cm, bei einer Dotierung üblicherweise mit Arsen, Antimon, Phosphor, Bor, Gallium oder Aluminium.

Die nach dem erfindungsgemäßen Verfahren erhältlichen Scheiben besitzen folgende zusätzliche Spezifikationen: Die Dicke der ersten Epitaxieschicht, die den Hauptteil der denuded zone bildet, ist variabel gestaltbar und beträgt bevorzugt 1 »m bis 20 »m, mit besonderem Vorteil 10 »m . Durch Ausdiffusion von Sauerstoff aus der Substratoberfläche während der Epitaxie erstreckt sich die gesamte denuded zone über die erste Epitaxieschicht hinaus noch 2 »m bis 10 »m in das Substrat hinein. In der denuded zone ist der Sauerstoffgehalt gegenüber dem Substrat stark verringert. Bevorzugt wird ein Sauerstoffgehalt von weniger als 1 x 10¹⁷ Atome/cm³ erreicht.
Die zweite epitaktisch abgeschiedene Schicht der Scheibe besitzt verfahrensbedingt einen ähnlich niedrigen Sauerstoffgehalt wie die erste Epitaxieschicht. Der spezifische Widerstand der zweiten Schicht weicht jedoch in der Regel von dem der ersten Schicht ab. Üblicherweise ist er höher und beträgt 0,1 Ohm cm bis 1000 Ohm cm, bevorzugt 3 Ohm cm. Die eingestellte Schichtdicke beträgt 1 »m bis 100 »m, vorzugsweise 3 »m. Als Dotierstoff wird eine Verbindung aus derselben Gruppe von Stoffen ausgewählt, wie zur Dotierung von Substrat oder erster Epitaxieschicht.

Halbleiterscheiben, die nach dem erfindungsgemäßen Verfahren hergestellt werden, besitzen eine Reihe vorteilhafter Eigenschaften. Durch das Abscheiden einer ersten sauerstofffreien Epitaxieschicht ist die Ausdehnung der entstehenden denuded zone frei einstellbar und genau reproduzierbar. Der Sauerstoffgehalt des Substrates hat auf ihre Entstehung praktisch keinen Einfluß. Die denuded zone zeichnet sich durch einen in ihrem Ausdehnungsbereich nur um bis zu 10% von einem Mittelwert abweichenden spezifischen Widerstand aus. Die Widerstandsänderung zur oberflächennahen Epitaxieschicht hin ist durch einen steilen Gradienten gekennzeichnet und ein weiteres wichtiges Qualitätskriterium. Zudem ist die Konzentration an Kristalldefekten in dieser Epitaxieschicht wesentlich geringer als die im Substrat.
Bisherige Verfahrensnachteile, wie das Autodoping durch lange Temperzeiten, der Memoryeffekt durch große Reaktorvolumina und eine Unwirtschaftlichkeit durch lange Verweilzeiten im Reaktor werden nach dem erfindungsgemäßen Verfahren weitgehend vermieden. Durch die Erfindung wird die Herstellung epitaxierter Scheiben mit einer denuded zone einstellbarer Ausdehnung besonders wirtschaftlich.

Im folgenden wird das erfindungsgemäße Verfahren anhand eines Ausführungsbeispiels erläutert. Das im Beispiel dargestellte Verfahren stellt nur eine erfindungsgemäße Ausführungsform zur Herstellung einer erfindungsgemäßen Halbleiterscheibe dar und stellt damit keine Einschränkung des Erfindungsgedankens auf diese Ausführungsform dar.

Eine einkristalline Siliciumscheibe der Kristallorientierung 1-0-0, einer Dicke von 725 »m und einem Durchmesser von 200 mm wird auf den 900°C heißen Suszeptor des Einzelscheibenreaktors gelegt. Die Prozeßkammer, die zuvor mit Wasserstoff gespült wurde, wird auf 1190°C aufgeheizt. Bei einem Wasserstofffluß von 20 Standardlitern pro Minute wird eine Suszeptorrotation von 25 U/Min aufrechterhalten.

Zur Stabilisierung vor der Abscheidung wird der Wasserstofffluß auf 60 Standardliter pro Minute erhöht und zur Erreichung des geforderten Widerstandswertes von 0.01 Ohm cm wird die Trichlorsilanspülung auf etwa 22 g/min und die Dotierung mit Diboran auf 1,8 Standardliter pro Minute bei 1000 ppm Diboran in Wasserstoff eingestellt.

Nach 50 Sekunden beginnt die Abscheidung der ersten, hochdotierten Epitaxieschicht, indem der Prozeßgasfluß auf die Prozeßkammer umgelenkt wird. Nach 135 Sekunden ist eine 10 »m dicke Schicht abgeschieden. Danach erfolgt eine 10 Sekunden lange Wasserstoffspülung bei 180 Standardliter pro Minute.

Dann wird die Temperatur auf 1055°C abgesenkt und der Wasserstofffluß auf 100 Standardliter pro Minute verringert. Die Dotierung wird auf 90 Standardkubikzentimeter pro Minute verringert, was einen Widerstand von etwa 3 Ohm cm ergibt. Nach einer Stabilisierungsphase wird bei sonst gleichen Parametern die zweite Epitaxieschicht mit einer Dicke von 2,8 »m bei einer Temperatur von 1080°C abgeschieden.

Nach einer Spülung der Kammer für 10 Sekunden mit Wasserstoff wird die Temperatur innerhalb von 30 Sekunden auf 900°C und der Wasserstofffluß auf 20 Standardliter pro Minute reduziert. Nach Beendigung der Suszeptorrotation wird die Scheibe unter Stickstoffspülung entladen.

Dann wird die Prozeßkammer ohne Scheibe für 35 Sekunden bei 1200°C mit einem Gemisch aus 20 Standardlitern pro Minute Wasserstoff und 20 Standardlitern pro Minute Chlorwasserstoff geätzt, für 7 Sekunden mit 100 Standardlitern pro Minute Wasserstoff gespült und wiederum 20 Sekunden lang geätzt.

Nach einer Absenkung der Temperatur auf 900°C, Erhöhung des Wasserstoffstroms und Abschalten des Chlorwasserstoffstroms folgt mit der Beladung der nächsten Scheibe ein neuer Prozeßzyklus.

## Patentansprüche (Patentansprüche für folgende(n) Vertragsstaat(en): DE, FR, GB)

1. Verfahren zur Herstellung von epitaxierten Siliciumscheiben mit sauerstoffarmer Schicht (denuded zone) gebildet durch Epitaxie einkristalliner Substratscheiben in einem Einzelscheibenreaktor, dadurch gekennzeichnet, daß zwei epitaktische Schichten unter Vergrößerung der Substratdicke nacheinander auf einer Seite der Substratscheibe abgeschieden werden, wobei die erste Epitaxieschicht so dotiert ist, daß sie denselben spezifischen Widerstand wie die Substratscheibe aufweist, und die sauerstoffarme Schicht die oberflächennahe Schicht der Substratscheibe und die zwei darüberliegenden epitaktischen Schichten umfaßt.

2. Verfahren nach Anspruch 1, gekennzeichnet dadurch, daß die Abscheidung durch Zersetzung eines oder mehrerer Gase aus der Gruppe von Tetrachlorsilan (SiCl₄), Trichlorsilan (SiCl₃H), Dichlorsilan (SiCl₂H₂) und Silan (SiH₄) erfolgt.

3. Verfahren nach Anspruch 1 oder 2, gekennzeichnet dadurch, daß die Abscheidung bei 1333 Pa bis Atmosphärendruck erfolgt.

4. Verfahren nach einem oder mehreren der Ansprüche 1 bis 3, gekennzeichnet dadurch, daß die Abscheidung bei einer Temperatur von 900°C - 1250°C erfolgt.

5. Verfahren nach einem oder mehreren der Ansprüche 1 bis 4, gekennzeichnet dadurch, daß eine erste epitaktische Schicht mit einer Schichtdicke von 1 »m bis 20 »m abgeschieden wird.

6. Verfahren nach einem oder mehreren der Ansprüche 1 bis 5, gekennzeichnet dadurch, daß eine zweite epitaktische Schicht mit einer Schichtdicke von 1 »m bis 100 »m abgeschieden wird.

7. Verfahren nach einem oder mehreren der Ansprüche 1 bis 6, gekennzeichnet dadurch, daß die epitaktischen Schichten mit einer Rate von 2 bis 6 »m pro Minute aufwachsen.

8. Verfahren nach einem oder mehreren der Ansprüche 1 bis 7, gekennzeichnet dadurch, daß vor dem epitaktischen Abscheiden eine Reaktor- und Scheibenbehandlung mit einem Ätzmittel erfolgt.

9. Verfahren nach Anspruch 8, gekennzeichnet dadurch, daß als Ätzmittel gasförmiger Chlorwasserstoff verwendet wird.

10. Verfahren nach einem der Ansprüche 1 bis 9, gekennzeichnet dadurch, daß die Abscheidung der Epitaxieschichten unter Zusatz von Dotiergasen aus der Gruppe von Diboran, Arsin und Phosphin erfolgt.

11. Siliciumscheibe mit zwei auf der Oberfläche einer einkristallinen Substratscheibe epitaktisch abgeschiedenen Schichten, hergestellt in einem Verfahren nach einem oder mehreren der Ansprüche 1 bis 10, gekennzeichnet dadurch, daß der Sauerstoffgehalt der ersten abgeschiedenen Schicht geringer ist als der der Substratscheibe, die erste abgeschiedene Schicht denselben spezifischen Widerstand wie die Substratscheibe aufweist, und die zweite abgeschiedene Schicht einen anderen spezifischen Widerstand als die erste abgeschiedene Schicht besitzt.

12. Siliciumscheibe nach Anspruch 11, gekennzeichnet dadurch, daß die Sauerstoffkonzentration in den abgeschiedenen Schichten geringer als 1 × 10¹⁷ Atome/cm³ ist.

13. Siliciumscheibe nach einem oder mehreren der Ansprüche 11 und 12, gekennzeichnet dadurch, daß der spezifische Widerstand der ersten Epitaxieschicht 0.005 Ohm cm bis 100 Ohm cm beträgt.

14. Siliciumscheibe nach einem oder mehreren der Ansprüche 11 bis 13, gekennzeichnet dadurch, daß der spezifische Widerstand der zweiten Epitaxieschicht 0.1 Ohm cm bis 1000 Ohm cm beträgt.

15. Siliciumscheibe nach einem oder mehreren der Ansprüche 11 bis 14, gekennzeichnet dadurch, daß die Schichtdicke der ersten Epitaxieschicht 1 »m - 20 »m beträgt.

16. Siliciumscheibe nach einem oder mehreren der Ansprüche 11 bis 15, gekennzeichnet dadurch, daß die Schichtdicke der zweiten Epitaxieschicht 1 »m - 100 »m beträgt.

## Patentansprüche (Patentansprüche für folgende(n) Vertragsstaat(en): BE, IT, NL)

1. Verfahren zur Herstellung von epitaxierten Siliciumscheiben mit sauerstoffarmer Schicht (denuded zone) gebildet durch Epitaxie einkristalliner Substratscheiben in einem Einzelscheibenreaktor, dadurch gekennzeichnet, daß zwei epitaktische Schichten unter Vergrößerung der Substratdicke nacheinander auf einer Seite der Substratscheibe abgeschieden werden, wobei die erste Epitaxieschicht so dotiert ist, daß sie denselben oder einen in Toleranzen von 5 bis 20% ähnlichen spezifischen Widerstand wie die Substratscheibe aufweist, und die sauerstoffarme Schicht eine oberflächennahe Schicht der Substratscheibe und die zwei darüberliegenden epitaktischen Schichten umfaßt.

2. Verfahren nach Anspruch 1, gekennzeichnet dadurch, daß die Abscheidung durch Zersetzung eines oder mehrerer Gase aus der Gruppe von Tetrachlorsilan (SiCl₄), Trichlorsilan (SiCl₃H), Dichlorsilan (SiCl₂H₂) und Silan (SiH₄) erfolgt.

3. Verfahren nach Anspruch 1 oder 2, gekennzeichnet dadurch, daß die Abscheidung bei 1333 Pa bis Atmosphärendruck erfolgt.

4. Verfahren nach einem oder mehreren der Ansprüche 1 bis 3, gekennzeichnet dadurch, daß die Abscheidung bei einer Temperatur von 900°C - 1250°C erfolgt.

5. Verfahren nach einem oder mehreren der Ansprüche 1 bis 4, gekennzeichnet dadurch, daß eine erste epitaktische Schicht mit einer Schichtdicke von 1 »m bis 20 »m abgeschieden wird.

6. Verfahren nach einem oder mehreren der Ansprüche 1 bis 5, gekennzeichnet dadurch, daß eine zweite epitaktische Schicht mit einer Schichtdicke von 1 »m bis 100 »m abgeschieden wird.

7. Verfahren nach einem oder mehreren der Ansprüche 1 bis 6, gekennzeichnet dadurch, daß die epitaktischen Schichten mit einer Rate von 2 bis 6 »m pro Minute aufwachsen,

8. Verfahren nach einem oder mehreren der Ansprüche 1 bis 7, gekennzeichnet dadurch, daß vor dem epitaktischen Abscheiden eine Reaktor- und Scheibenbehandlung mit einem Ätzmittel erfolgt.

9. Verfahren nach Anspruch 8, gekennzeichnet dadurch, daß als Ätzmittel gasförmiger Chlorwasserstoff verwendet wird.

10. Verfahren nach einem der Ansprüche 1 bis 9, gekennzeichnet dadurch, daß die Abscheidung der Epitaxieschichten unter Zusatz von Dotiergasen aus der Gruppe von Diboran, Arsin und Phosphin erfolgt.

11. Siliciumscheibe mit zwei auf der Oberfläche einer einkristallinen Substratscheibe epitaktisch abgeschiedenen Schichten, hergestellt in einem Verfahren nach einem oder mehreren der Ansprüche 1 bis 10, gekennzeichnet dadurch, daß der Sauerstoffgehalt der ersten abgeschiedenen Schicht geringer ist als der der Substratscheibe, die erste abgeschiedene Schicht denselben oder einen in Toleranzen von 5 bis 20% ähnlichen spezifischen Widerstand wie die Substratscheibe aufweist, und die zweite abgeschiedene Schicht einen anderen spezifischen Widerstand als die erste abgeschiedene Schicht besitzt.

12. Siliciumscheibe nach Anspruch 11, gekennzeichnet dadurch, daß die Sauerstoffkonzentration in den abgeschiedenen Schichten geringer als 1 × 10¹⁷ Atome/cm³ ist.

13. Siliciumscheibe nach einem oder mehreren der Ansprüche 11 und 12, gekennzeichnet dadurch, daß der spezifische Widerstand der ersten Epitaxieschicht 0.005 Ohm cm bis 100 Ohm cm beträgt.

14. Siliciumscheibe nach einem oder mehreren der Ansprüche 11 bis 13, gekennzeichnet dadurch, daß der spezifische Widerstand der zweiten Epitaxieschicht 0.1 Ohm cm bis 1000 Ohm cm beträgt.

15. Siliciumscheibe nach einem oder mehreren der Ansprüche 11 bis 14, gekennzeichnet dadurch, daß die Schichtdicke der ersten Epitaxieschicht 1 »m - 20 »m beträgt.

16. Siliciumscheibe nach einem oder mehreren der Ansprüche 11 bis 15, gekennzeichnet dadurch, daß die Schichtdicke der zweiten Epitaxieschicht 1 »m - 100 »m beträgt.

## Claims (Claims for the following Contracting State(s): DE, FR, GB)

1. Process for producing epitaxially coated silicon wafers having a low-oxygen layer (denuded zone) formed by epitaxy of monocrystalline substrate wafers in a single-wafer reactor, characterized in that two epitaxial layers are deposited consecutively on one side of the substrate wafer, with the substrate thickness being increased, the first epitaxial layer being doped in such a way that it has the same specific resistivity as the substrate wafer, and the low-oxygen layer comprising the substrate wafer layer close to the surface and the two epitaxial layers located above.

2. Process according to Claim 1, characterized in that the deposition is carried out by decomposing one or more gases from the group comprising tetrachlorosilane (SiCl₄), trichlorosilane (SiCl₃H), dichlorosilane (SiCl₂H₂) and silane (SiH₄).

3. Process according to Claim 1 or 2, characterized in that the deposition is carried out at 1333 Pa to atmospheric pressure.

4. Process according to one or more of Claims 1 to 3, characterized in that the deposition is carried out at a temperature of 900°C-1,250°C.

5. Process according to one or more of Claims 1 to 4, characterized in that a first epitaxial layer is deposited with a layer thickness of 1 »m to 20 »m.

6. Process according to one or more of Claims 1 to 5, characterized in that a second epitaxial layer having a layer thickness of 1 »m to 100 »m is deposited.

7. Process according to one or more of Claims 1 to 6, characterized in that the epitaxial layers grow at a rate of 2 to 6 »m per minute.

8. Process according to one or more of Claims 1 to 7, characterized in that, before the epitaxial deposition, a reactor treatment and wafer treatment is carried out with an etchant.

9. Process according to Claim 8, characterized in that gaseous hydrogen chloride is used as etchant.

10. Process according to one of Claims 1 to 9, characterized in that the deposition of the epitaxial layers is carried out with the addition of dopant gases from the group comprising diborane, arsine and phosphine.

11. Silicon wafer having two layers epitaxially deposited on the surface of a monocrystalline substrate wafer produced in a process according to one or more of Claims 1 to 10, characterized in that the oxygen content of the first layer deposited is less than that of the substrate wafer, the first layer deposited has the same resistivity as the substrate wafer, and the second layer deposited has a resistivity other than that of the first layer deposited.

12. Silicon wafer according to Claim 11, characterized in that the oxygen concentration in the layers deposited is less than 1 × 10¹⁷ atoms/cm³.

13. Silicon wafer according to one or more of Claims 11 and 12, characterized in that the resistivity of the first epitaxial layer is 0.005 Ω·cm to 100 Ω·cm.

14. Silicon wafer according to one or more of Claims 11 to 13, characterized in that the resistivity of the second epitaxial layer is 0.1 Ω·cm to 1,000 Ω·cm.

15. Silicon wafer according to one or more of Claims 11 to 14, characterized in that the layer thickness of the first epitaxial layer is 1 »m-20 »m.

16. Silicon wafer according to one or more of Claims 11 to 15, characterized in that the layer thickness of the second epitaxial layer is 1 »m-100 »m.

## Claims (Claims for the following Contracting State(s): BE, IT, NL)

1. Process for producing epitaxially coated silicon wafers having a low-oxygen layer (denuded zone) formed by epitaxy of monocrystalline substrate wafers in a single-wafer reactor, characterized in that two epitaxial layers are deposited consecutively on one side of the substrate wafer, with the substrate thickness being increased, the first epitaxial layer being doped in such a way that it has the same specific resistivity as the substrate wafer or similar within tolerances of 5 to 20%, and the low-oxygen layer comprising a substrate wafer layer close to the surface and the two epitaxial layers located above.

2. Process according to Claim 1, characterized in that the deposition is carried out by decomposing one or more gases from the group comprising tetrachlorosilane (SiCl₄), trichlorosilane (SiCl₃H), dichlorosilane (SiCl₂H₂) and silane (SiH₄).

3. Process according to Claim 1 or 2, characterized in that the deposition is carried out at 1333 Pa to atmospheric pressure.

4. Process according to one or more of Claims 1 to 3, characterized in that the deposition is carried out at a temperature of 900°C-1,250°C.

5. Process according to one or more of Claims 1 to 4, characterized in that a first epitaxial layer is deposited with a layer thickness of 1 »m to 20 »m.

6. Process according to one or more of Claims 1 to 5, characterized in that a second epitaxial layer having a layer thickness of 1 »m to 100 »m is deposited.

7. Process according to one or more of Claims 1 to 6, characterized in that the epitaxial layers grow at a rate of 2 to 6 »m per minute.

8. Process according to one or more of Claims 1 to 7, characterized in that, before the epitaxial deposition, a reactor treatment and wafer treatment is carried out with an etchant.

9. Process according to Claim 8, characterized in that gaseous hydrogen chloride is used as etchant.

10. Process according to one of Claims 1 to 9, characterized in that the deposition of the epitaxial layers is carried out with the addition of dopant gases from the group comprising diborane, arsine and phosphine.

11. Silicon wafer having two layers epitaxially deposited on the surface of a monocrystalline substrate wafer produced in a process according to one or more of Claims 1 to 10, characterized in that the oxygen content of the first layer deposited is less than that of the substrate wafer, the first layer deposited has the same resistivity or similar within tolerances of 5 to 20% as the substrate wafer, and the second layer deposited has a resistivity other than that of the first layer deposited.

12. Silicon wafer according to Claim 11, characterized in that the oxygen concentration in the layers deposited is less than 1 × 10¹⁷ atoms/cm³.

13. Silicon wafer according to one or more of Claims 11 and 12, characterized in that the resistivity of the first epitaxial layer is 0.005 Ω·cm to 100 Ω·cm.

14. Silicon wafer according to one or more of Claims 11 to 13, characterized in that the resistivity of the second epitaxial layer is 0.1 Ω·cm to 1,000 Ω·cm.

15. Silicon wafer according to one or more of Claims 11 to 14, characterized in that the layer thickness of the first epitaxial layer is 1 »m-20 »m.

16. Silicon wafer according to one or more of Claims 11 to 15, characterized in that the layer thickness of the second epitaxial layer is 1 »m-100 »m.

## Revendications (Revendications pour l'(les) Etat(s) contractant(s) suivant(s): DE, FR, GB)

1. Procédé pour la préparation de disques de silicium épitaxiés avec une couche pauvre en oxygène ("denuded zone") formée par épitaxie de disques-substrat monocristallins dans un réacteur à disques individuels, caractérisé en ce qu'on dépose, l'une après l'autre, deux couches épitaxiées en augmentant l'épaisseur du substrat sur un côté du disque-substrat, la première couche épitaxiale étant dopée de telle façon qu'elle présente la même résistance spécifique que le disque-substrat et que la couche pauvre en oxygène comprenne la couche proche de la surface du disque-substrat et les deux couches épitaxiées qui la recouvrent.

2. Procédé selon la revendication 1, caractérisé en ce que le dépôt est effectuée par la décomposition d'un ou de plusieurs gaz du groupe du tétrachlorosilane (SiCl₄), du trichlorosilane (SiCl₃H), du dichlorosilane (SiCl₂H₂) et du silane (SiH₄).

3. Procédé selon la revendication 1 ou 2, caractérisé en ce qu'on effectue le dépôt à une pression de 1333 Pa jusqu'à la pression atmosphérique.

4. Procédé selon une ou plusieurs des revendications 1 à 3, caractérisé en ce qu'on effectue le dépôt à une température de 900 à 1250 °C.

5. Procédé selon une ou plusieurs des revendications 1 à 4, caractérisé en ce qu'on dépose une première couche épitaxiée d'une épaisseur de 1 »m à 20 »m.

6. Procédé selon une ou plusieurs des revendications 1 à 5, caractérisé en ce qu'on dépose une deuxième couche épitaxiée d'une épaisseur de 1 »m à 100 »m.

7. Procédé selon une ou plusieurs des revendications 1 à 6, caractérisé en ce que l'épaisseur les couches épitaxiées augmente avec un taux de 2 à 6 »m/minute.

8. Procédé selon une ou plusieurs des revendications 1 à 7, caractérisé en ce qu'avant le dépôt par épitaxie on effectue un décapage du réacteur et un traitement décapant des disques.

9. Procédé selon la revendication 8, caractérisé en ce qu'on utilise en tant qu'agent de décapage l'hydrogène chloré gazeux.

10. Procédé selon l'une des revendications 1 à 9, caractérisé en ce qu'on effectue le dépôt des couches épitaxiées par addition de gaz de dopage pris dans le groupe comprenant le diborane, l'arsine et la phosphine.

11. Disque de silicium avec deux couches déposées par épitaxie sur la surface d'un disque-substrat monocristallin, préparé selon un procédé selon une ou plusieurs des revendications 1 à 10, caractérisé en ce que la teneur en oxygène de la première couche déposée est plus faible que celle du disque-substrat, la première couche déposée présente la même résistance spécifique que celle du disque-substrat et que la deuxième couche déposée a une résistance spécifique différente de celle de la première couche déposée.

12. Disque de silicium selon la revendication 11, caractérisé en ce que la concentration en oxygène dans les couches déposées est inférieure à 1 × 10¹⁷ atomes/cm³.

13. Disque de silicium selon une ou plusieurs des revendications 11 et 12, caractérisé en ce que la résistance spécifique de la première couche épitaxiale est de 0,005 Ohm cm à 100 Ohm cm.

14. Disque de silicium selon une ou plusieurs des revendications 1 à 13, caractérisé en ce que la résistance spécifique de la deuxième couche épitaxiale est de 0,1 Ohm cm à 1000 Ohm cm.

15. Disque de silicium selon une ou plusieurs des revendications 11 à 14, caractérisé en ce que l'épaisseur de la première couche épitaxiale est de 1 »m à 20 »m.

16. Disque de silicium selon une ou plusieurs des revendications 1 à 15, caractérisé en ce que l'épaisseur de la deuxième couche épitaxiale est de 1 »m à 100 »m.

## Revendications (Revendications pour l'(les) Etat(s) contractant(s) suivant(s): BE, IT, NL)

1. Procédé pour la préparation de disques de silicium par épitaxie comportant une couche pauvre en oxygène ("denuded zone") formée par épitaxie de disques-substrat monocristallinsdans un réacteur à disques individuels, caractérisé en ce qu'on dépose deux disques épitaxiés en augmentant l'épaisseur du substrat, l'une après l'autre, sur un côté du disque-substrat, la première couche épitaxiée étant dopée de telle façon qu'elle présente la même résistance spécifique ou une résistance spécifique simialire, dans des limites de tolérances de 5 à 20 %, à celle du disque de substrat, et que la couche pauvre en oxygène comprenne une couche proche de la surface du disque-substrat et les deux couches épitaxiales qui la recouvrent.

2. Procédé selon la revendication 1, caractérisé en ce le dépôt est effectuée par la décomposition d'un ou de plusieurs gaz du groupe du tétrachlorosilane (SiCl₄), du trichlorosilane (SiCl₃H), du dichlorosilane (SiCl₂H₂) et du silane (SiH₄).

3. Procédé selon la revendication 1 ou 2, caractérisé en ce qu'on effectue le dépôt à une pression 1333 Pa jusqu'à la pression atmosphérique.

4. Procédé selon une ou plusieurs des revendications 1 à 3, caractérisé en ce qu'on effectue le dépôt à une température de 900 à 1250 °C.

5. Procédé selon une ou plusieurs des revendications 1 à 4, caractérisé en ce qu'on dépose une première couche épitaxiale d'une épaisseur de 1 »m à 20 »m.

6. Procédé selon une ou plusieurs des revendications 1 à 5, caractérisé en ce qu'on dépose une deuxième couche épitaxiale d'une épaisseur de 1 »m à 100 »m.

7. Procédé selon une ou plusieurs des revendications 1 à 6, caractérisé en ce que les couches épitaxiales augmentent leur épaisseur avec un taux de 2 à 6 »m/minute.

8. Procédé selon une ou plusieurs des revendications 1 à 7, caractérisé en ce qu'avant le dépôt épitaxiale on effectue un décapage du réacteur et un traitement décapant des disques.

9. Procédé selon la revendication 8, caractérisé en ce qu'on utilise en tant qu'agent de décapage l'hydrogène chloré gazeux.

10. Procédé selon l'une des revendications 1 à 9, caractérisé en ce qu'on effectue le dépôt des couches épitaxiées par addition de gaz de dopage pris dans le groupe comprenant le diborane, l'arsine et la phosphine.

11. Disque de silicium avec deux couches déposées par épitaxie sur la surface d'un disque-substrat monocristallin, préparé selon un procédé selon une ou plusieurs des revendications 1 à 10, caractérisé en ce que la teneur en oxygène de la première couche déposée est plus faible que celle du disque de substrat, la première couche déposée présente la même résistance spécifique ou une résistance spécifique similaire, située dans le domaine de tolérances de 5 à 20 %, à celle du disque du substrat et que la deuxième couche déposée a une résistance spécifique différente de celle de la première couche déposée.

12. Disque de silicium selon la revendication 11, caractérisé en ce que la concentration en oxygène dans les couches déposées est inférieure à 1 × 10¹⁷ atomes/cm³.

13. Disque de silicium selon une ou plusieurs des revendications 11 et 12, caractérisé en ce que la résistance spécifique de la première couche épitaxiale est de 0,005 Ohm cm à 100 Ohm cm.

14. Disque de silicium selon une ou plusieurs des revendications 1 à 13, caractérisé en ce que la résistance spécifique de la deuxième couche épitaxiale est de 0,1 Ohm cm à 1000 Ohm cm.

15. Disque de silicium selon une ou plusieurs des revendications 11 à 14, caractérisé en ce que l'épaisseur de la première couche épitaxiale est de 1 »m à 20 »m.

16. Disque de silicium selon une ou plusieurs des revendications 1 à 15, caractérisé en ce que l'épaisseur de la deuxième couche épitaxiale est de 1 »m à 100 »m.
